# EUROPÄISCHE PATENTSCHRIFT

(11) **EP 1 308 978 B1**
(45) Veröffentlichungstag und Bekanntmachung des Hinweises auf die Patenterteilung: **08.05.2013**
(21) Anmeldenummer: 02022710.4
(22) Anmeldetag: 10.10.2002
(51) Int. Cl.: H01H 85/044, H01H 85/046, H01H 85/43

(54) **Sicherungsgehäuse**
Fuse casing
Boîtier pour fusible

(30) Priorität: 05.11.2001 DE 10153814
(43) Veröffentlichungstag der Anmeldung: 07.05.2003
(73) Patentinhaber: OSRAM GmbH, 80807 München (DE)
(72) Erfinder: Werni, Horst, 80937 München (DE)

(56) Entgegenhaltungen:
- EP-A- 1 045 625
- DE-A- 3 447 502
- DE-A- 3 723 832
- DE-U- 29 913 347
- GB-A- 1 024 192
- US-A- 5 179 436

## Beschreibung

### Technisches Gebiet

Die Erfindung geht aus von einer Sicherungsvorrichtung für Elektrogeräte gemäß dem Oberbegriff des Anspruchs 1. Es handelt sich dabei insbesondere um eine kostengünstige Überstromsicherung, die durch konstruktive Merkmale beim Ansprechen der Sicherungsvorrichtung nicht die Gefahr einer Lichtbogenbildung durch verdampfende Metallteile birgt.

### Stand der Technik

Wird für ein Elektrogerät die Betriebsspannung aus einer Netzspannungsversorgung entnommen, so müssen, entsprechend einschlägigen Vorschriften (z.B. EN60928 im Falle Beleuchtungstechnik), Betriebsspannungs-Zuleitungen zu diesem Gerät gegen Überstrom abgesichert werden. Aus diesem Grund muss das Elektrogerät eine Sicherungsvorrichtung enthalten, die den Betriebsstrom, den das Elektrogerät der Netzspannungsversorgung entnimmt, überwacht. Im Fehlerfall, wenn der Betriebsstrom einen Wert erreicht, der eine gegebene Schwelle übersteigt und somit als Überstrom eingestuft wird, spricht die Sicherungsvorrichtung an, d. h. sie unterbricht die Stromzufuhr von der Netzspannungsversorgung zum Elektrogerät.

Üblich ist die Verwendung einer Schmelzsicherung als Sicherungsvorrichtung. Dabei verläuft in einem Glasrohr ein Sicherungsdraht, über den der Betriebsstrom geführt wird. Bei Überstrom schmilzt der Sicherungsdraht und unterbricht den Betriebsstrom. Bei Elektrogeräten, die in einer niedrigen Preiskategorie eingestuft werden können, bedeutet der Einsatz einer Schmelzsicherung eine erhebliche Kostensteigerung. Deshalb wird bei diesen Geräten versucht, eine Alternative zur Schmelzsicherung zu verwenden, insbesondere dann, wenn eine Reparatur des Elektrogeräts nach einem Fehlerfall nicht vorgesehen ist. Zum Einsatz kommen elektrisch leitende Elemente, die bei Erreichen des Überstroms schmelzen. Diese Elemente können beispielsweise Widerstände oder Drosselspulen sein, die vom Betriebsstrom durchflossen werden und außer der Funktion als Sicherungsvorrichtung noch andere Funktionen übernehmen können.

Weit verbreitet sind sog. Leiterbahnsicherungen als Ersatz für eine Schmelzsicherung. Dabei wird eine vorhandenen Leiterplatte benutzt, auf die Leiterbahnen aufgebracht sind. In der Regel werden dem Elektrogerät zwei Betriebsspannungs-Zuleitungen zugeführt, wobei jede mit je einer Leiterbahn verbunden ist. Damit bilden sich eine erste und eine zweite Betriebsspannungs-Potenzialfläche in Form besagter Leiterbahnen aus. Beispielsweise die erste Betriebsspannungs-Potenzialfläche ist zweigeteilt, um das elektrisch leitende Element einfügen zu können, über das der Betriebsstrom führt. Im Fall der Leiterbahnsicherung wird das elektrisch leitende Element als ein dünnes Stück Leiterbahn ausgeführt, das so ausgelegt ist, dass es bei Überstrom schmilzt.

Bei den erwähnten Sicherungsvorrichtungen, die die Schmelzsicherung ersetzen, insbesondere aber bei der Leiterbahnsicherung, tritt folgendes Problem auf: Beim Ansprechen der Sicherung bildet sich Metalldampf, der sich über der ersten und der zweiten Betriebsspannungs-Potenzialfläche ausbreitet. Dadurch kann es zur Ausbildung eines Lichtbogens zwischen beiden Betriebsspannungs-Potenzialflächen kommen. Dies führt im besten Fall zu einer vorschriftswidrigen Auslösung dem Elektrogerät vorgeordneter Sicherungen. Im schlimmsten Fall wird dadurch ein Brand verursacht.

Zur Vermeidung des o. g. Lichtbogens, wird in der Schrift DE 37 23 832 vorgeschlagen, die Leiterbahnsicherung mit einem Abdecklack zu versehen. Auch bekannt ist das Kapseln der Leiterbahnsicherung in einem durch Begrenzungswände gebildeten geschlossenen Hohlkörpers. Damit soll verhindert werden, dass sich der o. g. Metalldampf ausbreitet. Dabei muss natürlich die zweite Betriebsspannungs-Potenzialfläche außerhalb des Hohlkörpers liegen. Beim Aufschmelzen des o. g. elektrisch leitenden Elements kann jedoch so viel Energie frei werden, dass die erwähnten Mittel nicht ausreichen, um die Ausbildung eines Lichtbogens zwischen den Betriebsspannungs-Potenzialflächen zu verhindern. Insbesondere kann es vorkommen, dass der o.g. Hohlkörper dem beim Ansprechen der Sicherungsvorrichtung entstehenden Druck nicht standhält und Metalldampf entweicht.

Dokument EP-A-1045625 offenbart eine Sicherungsvorrichtung gemäß dem Oberbegriff des Anspruchs 1.

### Darstellung der Erfindung

Es ist Aufgabe der vorliegenden Erfindung, eine kostengünstige Sicherungsvorrichtung gemäß dem Oberbegriff des Anspruchs 1 bereitzustellen, die eine zuverlässige Unterbrechung des Betriebsstroms im Überstrom-Fall bewerkstelligt.

Diese Aufgabe wird durch eine Sicherungsvorrichtung mit den Merkmalen des Oberbegriffs des Anspruchs 1 durch die Merkmale des kennzeichnenden Teils des Anspruchs 1 gelöst. Besonders vorteilhafte Ausgestaltungen finden sich in den abhängigen Ansprüchen.

Ausgangspunkt der erfindungsgemäßen Sicherungsvorrichtung ist eine Sicherungsvorrichtung, mit einem elektrisch leitenden Element, das in einem Hohlkörper zu liegen kommt. Allerdings ist der Hohlkörper nicht geschlossen, sondern er weist eine Öffnung auf. Die Öffnung ist dabei so bemessen, dass der Druck, der sich im Hohlkörper beim Ansprechen der Sicherung aufbaut nur so groß wird, dass der entstehende Metalldampf im wesentlichen durch die Öffnung entweicht. Damit wird eine unkontrollierte Verbreitung von Metalldampf durch Undichtigkeiten des Hohlkörpers vermieden.

Neben dem Vorhandensein einer Öffnung ist die Anordnung der Öffnung wichtig. Die Öffnung ist an einer Stelle des Hohlkörpers angeordnet, die ein Ausbreiten von Metalldampf in Richtung der zweiten Betriebsspannungs-Potenzialfläche verhindert. Die Raumrichtung, in die die Öffnung des Hohlkörpers weist, unterscheidet sich also von der Raumrichtung in der vom Hohlkörper aus gesehen die zweite Betriebsspannungs-Potenzialfläche liegt. Im Falle des Ansprechens der Sicherungsvorrichtung wird demgemäss bei der vorliegenden Erfindung der entstehende Metalldampf gezielt in eine Richtung gelenkt. Diese Richtung ist so gewählt, dass das entstehen eines Lichtbogens zwischen den Betriebsspannungs-Potenzialflächen vermieden wird.

Vorteilhaft wird die Erfindung in Zusammenhang mit der beschriebenen Leiterbahnsicherung angewandt. Die Leiterbahnsicherung benötigt kein zusätzliches elektrisch leitendes Element und ist deshalb besonders kostengünstig.

Der Aufbau des Hohlkörpers geschieht erfindungsgemäß mit Begrenzungswänden, die das Elektrogerät ohnehin enthält oder die kostenneutral hergestellt werden können. Vorzugsweise wird eine Begrenzungswand des Hohlkörpers durch die Leiterplatte gebildet.

Meist besteht das Gehäuse des Elektrogeräts aus Spritzgussteilen. Diese lassen sich kostenneutral so ausgestalten, dass sie Wände aufweisen, die als Begrenzungswände des Hohlkörpers dienen können. Der Hohlkörper kann somit auf einer Seite durch die Leiterplatte und auf den restlichen Seiten durch Teile des Gehäuses des Elektrogeräts begrenzt werden.

Die Begrenzungswände, die durch Gehäuseteile gebildet werden, werden so ausgestaltet, dass sich eine erfindungsgemäße Öffnung des Hohlkörpers ergibt.

Elektronische Betriebsgeräte für elektrische Lampen unterliegen einem großen Kostendruck. Deshalb wird versucht die vorgeschriebene Sicherungsvorrichtung möglichst kostengünstig zu realisieren. Aus diesem Grund wird für elektronische Betriebsgeräte bevorzugt eine erfindungsgemäße Sicherungsvorrichtung verwendet.

### Beschreibung der Zeichnungen

Im folgenden soll die Erfindung anhand eines Ausführungsbeispiels näher erläutert werden. Es zeigen:
- Figur 1: eine Draufsicht eines Elektrogeräts
- Figur 2: eine Seitenansicht eines Elektrogeräts (Schnitt A-A von Figur 1)

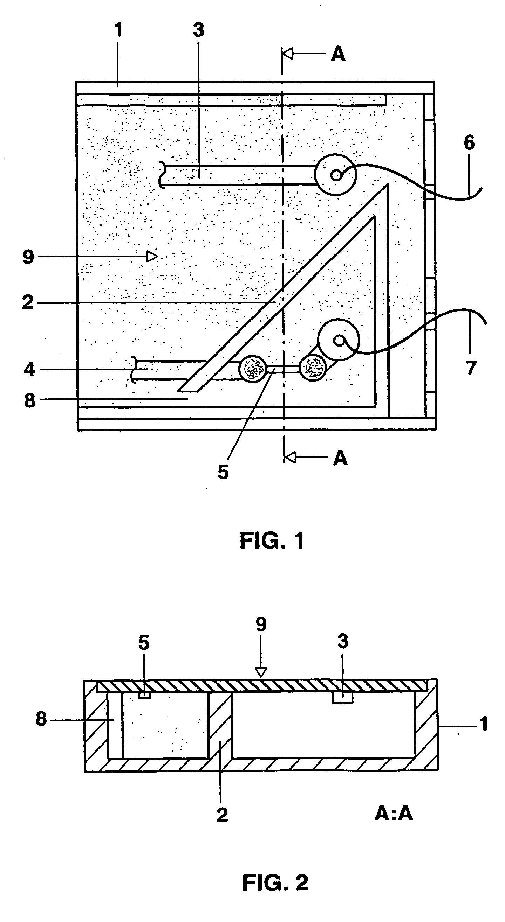

In Figur 1 ist die Draufsicht des Teils eines Elektrogeräts dargestellt, dem die Betriebsspannungs-Zuleitungen zugeführt werden. Bei dem Elektrogerät kann es sich beispielsweise um ein elektronisches Vorschaltgerät für elektrische Lampen handeln. In einem Gehäuseteil 1, das vorzugsweise aus Kunststoff (z.B. Polycarbonat, ABS) besteht, wird eine Leiterplatte 9 eingelegt. Sie liegt auf einem Steg 2 auf, wodurch ein Hohlkörper entsteht, dessen Begrenzungswände von der Leiterplatte 9, dem Gehäuseteil 1 und dem Steg 2 gebildet wird. Betriebsspannungs-Zuleitungen 6,7 sind mit Leiterbahnen 3,4 verbunden, die auf der Leiterplatte 9 aufgebracht sind. Damit bildet die Leiterbahn 4 eine erste und die Leiterbahn 3 eine zweite Betriebsspannungs-Potenzialfläche. Die Leiterbahn 4 ist zweigeteilt. Die Betriebsspannungs-Zuleitung 7 ist mit einem ersten Teil der Leiterbahn 4 verbunden. Der erste Teil ist mit einem zweiten Teil über die Leiterbahnsicherung 5 verbunden. Die Leiterbahnsicherung 5 ist ein elektrisch leitendes Element, das durch eine Verjüngung der Leiterbahn 4 entsteht. Diese Verjüngung ist so bemessen, dass im Überstrom-Fall die Leiterbahnsicherung 5 schmilzt. Deutlich ist zu erkennen, dass die zweite Betriebsspannungs-Potenzialfläche, die durch die Leiterbahn 3 gebildet wird, nicht im besagten Hohlkörper zu liegen kommt.

Erfindungsgemäß ist der besagte Hohlkörper nicht geschlossen, sondern weist eine Öffnung 8 auf. Diese entsteht durch eine ca. 1mm breite Aussparung im Steg 2. Spricht die Leiterbahnsicherung 5 an, so entweicht der entstehende Metalldampf über die Öffnung 8 aus dem Hohlkörper. Die Öffnung 8 ist so groß bemessen, dass der Druck im Hohlkörper nicht ausreicht, um Metalldampf zwischen der Leiterplatte 9 und dem Steg 2 entweichen zu lassen. Die Raumrichtung in die der Metalldampf beim Ansprechen der Leiterbahnsicherung entweicht ist durch die Lage der Öffnung 8 so gewählt, dass sie abweicht von der Raumrichtung, in der die zweite Betriebsspannungs-Potenzialfläche, gebildet durch die Leiterbahn 4, liegt. Damit kann sich der Metalldampf nicht über beide Betriebsspannungs-Potenzialflächen legen und einen Lichtbogen verursachen.

In Figur 2 ist ein Schnitt A-A der Figur 1 dargestellt. Gleiche Objekte werden in beiden Figuren mit gleichen Bezugszeichen bezeichnet. Deutlich ist zu erkennen wie die Leiterplatte 9 auf dem Gehäuseteil 1 aufliegt. Der Steg 2, der an das Gehäuseteil 1 angespritzt ist, bildet eine Begrenzungswand des Hohlkörpers, der die erfindungsgemäße Öffnung 8 aufweist. Die Leiterbahnsicherung 5 wird vom Hohlkörper umschlossen, während die zweite Betriebsspannungs-Potenzialfläche außerhalb des Hohlkörpers liegt.

## Patentansprüche

1. Sicherungsvorrichtung zum sichern eines Elektrogeräts gegen Überstrom mit folgenden Merkmalen:
• ein elektrisch leitendes Element (5), das bei Erreichen des Überstroms schmilzt,
• eine erste (4) und eine zweite Betriebsspannungs-Potenzialfläche (3), die jeweils mit einer Betriebsspannungs-Zuleitung (6,7) verbunden sind,
• die erste Betriebsspannungs-Potenzialfläche (4) ist zweigeteilt, wobei beide Teile durch das elektrisch leitende Element (5) verbunden sind,
• Begrenzungswände, die einen Hohlkörper bilden, wobei das elektrisch leitende Element (5) innerhalb und die zweite Betriebsspannungs-Potenzialfläche (3) außerhalb des Hohlkörpers liegen,
• eine Öffnung (8), die mindestens so groß ist, dass ein Austritt von Metalldampf in einem Auslösefall im wesentlichen durch diese Öffnung (8) erfolgt, wobei
• die Öffnung in eine Raumrichtung weist, die abweichend ist, zur Raumrichtung, in der die zweite Betriebsspannungs-Potenzialfläche (3) liegt,
**dadurch gekennzeichnet, dass** der Hohlkörper folgende Merkmale umfasst:
• eine Begrenzungswand des Hohlkörpers wird von einem Gehäuseteil (1) des Elektrogeräts gebildet,
• die Öffnung (8) des Hohlkörpers wird durch eine Aussparung in einem Gehäuseteil des Elektrogeräts gebildet.

2. Sicherungsvorrichtung gemäß Anspruch 1, **dadurch gekennzeichnet, dass** es sich bei dem Elektrogerät um ein elektronisches Betriebsgerät für elektrische Lampen handelt.

3. Sicherungsvorrichtung gemäß Anspruch 1, **dadurch gekennzeichnet, dass** das elektrisch leitende Element (5) von einer Leiterbahn gebildet wird, die auf einer Leiterplatte (9) aufgebracht ist.

4. Sicherungsvorrichtung gemäß Anspruch 1, **dadurch gekennzeichnet, dass** eine Begrenzungswand des Hohlkörpers von einer Leiterplatte gebildet wird.

## Claims

1. Protective device for safeguarding an electrical device against overcurrent, having the following features:
• an electrically conducting element (5) that fuses when the overcurrent is reached,
• a first (4) and a second operating voltage potential surface (3), which are connected in each case to an operating voltage supply lead (6, 7),
• the first operating voltage potential surface (4) is split into two, the two parts being connected by the electrically conducting element (5), and
• bounding walls that form a hollow body, the electrically conducting element (5) being situated inside, and the second operating voltage potential surface (3) being situated outside the hollow body,
• an opening (8) that is at least so large that, in the event of tripping, metal vapor exits substantially through this opening (8),
• the opening points in a direction in space that differs from the direction in space in which the second operating voltage potential surface (3) is situated,
**characterized in that** the hollow body comprises the following features:
• a bounding wall of the hollow body is formed by a housing part (1) of the electrical device,
• the opening (8) of the hollow body is formed by a cutout in the housing part of the electrical device.

2. Protective device according to Claim 1, **characterized in that** the electrical device is an electronic operating device for electric lamps.

3. Protective device according to Claim 1, **characterized in that** the electrically conducting element (5) is formed by a conductor track that is applied to a printed circuit board (9).

4. Protective device according to Claim 1, **characterized in that** a bounding wall of the hollow body is formed by a printed circuit board.

## Revendications

1. Dispositif de protection pour protéger un appareil électrique contre les surintensités de courant, présentant les caractéristiques suivantes :
• un élément électroconducteur (5) qui fond lorsque la surintensité de courant est atteinte,
• une première (4) et une deuxième surface de potentiel de tension de fonctionnement (3), respectivement reliées à une ligne d'alimentation en tension de fonctionnement (6, 7),
• la première surface de potentiel de tension de fonctionnement (4) est divisée en deux, les deux parties étant reliées par l'élément électroconducteur (5),
• des parois de délimitation qui forment un corps creux, l'élément électroconducteur (5) étant situé à l'intérieur, la deuxième surface de potentiel de tension de fonctionnement (3) à l'extérieur du corps creux,
• un orifice (8) qui est suffisamment grand pour qu'un échappement de vapeur métallique en cas de déclenchement se fasse essentiellement à travers cet orifice (8),
• ledit orifice étant orienté dans une direction spatiale qui est différente de celle dans laquelle est située la deuxième surface de potentiel de tension de fonctionnement (3),
**caractérisé en ce que** le corps creux comprend les caractéristiques suivantes :
• l'une des parois de délimitation du corps creux est formée par un élément de boîtier (1) de l'appareil électrique,
• l'orifice (8) du corps creux est formé par un évidement ménagé dans un élément de boîtier de l'appareil électrique.

2. Dispositif de protection selon la revendication 1, **caractérisé en ce que** l'appareil électrique est un appareil électronique pour faire fonctionner des lampes électriques.

3. Dispositif de protection selon la revendication 1, **caractérisé en ce que** l'élément électroconducteur (5) est formé par une piste conductrice appliquée sur une carte imprimée (9).

4. Dispositif de protection selon la revendication 1, **caractérisé en ce que** l'une des parois de délimitation du corps creux est formée par une carte imprimée.
